# EUROPEAN PATENT SPECIFICATION

(11) **EP 3 703 137 B1**
(45) Date of publication and mention of the grant of the patent: **04.11.2026**
(21) Application number: 18870149.4
(22) Date of filing: 26.09.2018
(51) Int. Cl.: H10D 8/60, H10D 62/80

(54) **SCHOTTKY BARRIER DIODE**
SCHOTTKY-BARRIEREN-DIODE
DIODE À BARRIÈRE DE SCHOTTKY

(30) Priority: 26.10.2017 JP 2017206978
(43) Date of publication of application: 02.09.2020
(73) Proprietor: TDK Corporation, Tokyo 103-6128 (JP); Tamura Corporation, Tokyo 178-8511 (JP); Novel Crystal Technology, Inc., Sayama-shi, Saitama 350-1328 (JP)
(72) Inventor: ARIMA, Jun, Tokyo 108-0023 (JP); HIRABAYASHI, Jun, Tokyo 108-0023 (JP); FUJITA, Minoru, Tokyo 108-0023 (JP); SASAKI, Kohei, Sayama City Saitama 350-1328 (JP)
(74) Representative: Epping - Hermann - Fischer
(86) International application number: PCT/JP2018/035645
(87) International publication number: WO 2019/082580

(56) References cited:
- WO-A1-2016/013554
- CN-A- 103 258 861
- US-A1- 2015 333 133
- US-A1- 2015 333 133
- US-A1- 2016 254 357
- SASAKI KOHEI ET AL: "First Demonstration of Ga2O3 Trench MOS-Type Schottky Barrier Diodes", IEEE ELECTRON DEVICE LETTERS, IEEE, USA, vol. 38, no. 6, 1 June 2017 (2017-06-01), pages 783 - 785, XP011649879, ISSN: 0741-3106, [retrieved on 20170522], DOI: 10.1109/LED.2017.2696986
- SASAKI KOHEI: "15P-315-13 Ga2O3 Schottky barrier diode provided with trench MOS structure", 64TH JSAP SPRING MEETING KOEN YOKOSHU. JAPAN SOCIETY OF APPLIED PHYSICS AND RELATED SOCIETIES (JSAP) ; 64 (YOKOHAMA) : 2017.03.14-17,20170301THE JAPAN SOCIETY OF APPLIED PHYSICS (JSAP), vol. 64, 1 March 2017 (2017-03-01), pages 12 - 169, XP009517927

## Description

### [Technical Field]

The present invention relates to a Schottky barrier diode and, more particularly, to a Schottky barrier diode using gallium oxide.

### [Background Art]

A Schottky barrier diode is a rectifying element utilizing a Schottky barrier generated due to bonding between metal and a semiconductor and is lower in forward voltage and higher in switching speed than a normal diode having a PN junction. Thus, the Schottky barrier diode is sometimes utilized as a flyback diode of a switching element.

When the Schottky barrier diode is utilized as a flyback diode of a switching element, it is necessary to ensure a sufficient backward withstand voltage, so that, silicon carbide (SiC), gallium nitride (GaN), or gallium oxide (Ga₂O₃) having a larger band gap is sometimes used in place of silicon (Si). Among them, gallium oxide has a very large band gap (4.8 eV to 4.9 eV) and a large breakdown field (about 8 MV/cm), so that a Schottky barrier diode using gallium oxide is very promising as the flyback diode of the switching element. An example of the Schottky barrier diode using gallium oxide is described in Patent Document 1 and Non-Patent Document 1. Further examples for Schottky barrier diodes are described in Patent Documents 2 to 4 and Non-Patent Document 2.

In the Schottky barrier diodes described in Non-Patent Documents 1 and 2, a plurality of trenches are formed so as to overlap an anode electrode in a plan view, and the inner wall of each of the trenches is covered with an insulating film. With this structure, when a backward voltage is applied, a mesa region positioned between adjacent trenches becomes a depletion layer, so that a channel region of a drift layer is pinched off. Thus, a leak current upon application of the backward voltage can be significantly reduced.

### [Citation List]

### [Patent Documents]

[Patent Document 1] JP 2017-045969 A
[Patent Document 2] US 2016/254357 A1
[Patent Document 3] US 2015/333133 A1
[Patent Document 4] CN 103258861 A

### [Non-Patent Documents]

[Non-Patent Document 1] Ga2O3 Schottky Barrier Diode with Trench MOS Structure (The 64th Spring Meeting of the Japan Society of Applied Physics, 2017 [15p-315-13])
[Non-Patent Document 2] First Demonstration of Ga203 Trench MOS-Type Schottky Barrier Diodes (IEEE ELECTRON DEVICE LETTERS, vol. 38, no. 6, 1 June 2017, pages 783-785)

### [Summary of Invention]

### [Problem to be Solved by the Invention]

However, in the Schottky barrier diodes described in Patent Document 1 and Non-Patent Documents 1 and 2, an electric field concentrates on the end portion of the anode electrode, so that when a high voltage is applied, dielectric breakdown occurs in this portion. For example, in the Schottky barrier diodes described in Non-Patent Documents 1 and 2, an electric field concentrates on an edge part of the trench positioned at the end portion.

It is therefore an object of the present embodiment to provide a Schottky barrier diode using gallium oxide, which is less likely to cause dielectric breakdown due to concentration of an electric field.

### [Means for Solving the Problem]

A Schottky barrier diode according to the present invention is defined in claim 1. Advantageous embodiments are set out in the dependent claims.

According to the present invention, the width of the trench positioned at the end portion is increased, so that the curvature radius of the bottom portion of this trench is increased. Alternatively, not forming an embodiment of the invention, an edge part constituted by the bottom portion as viewed in a cross section could be divided into two parts. As a result, an electric field to be applied to the bottom portion of the trench positioned at the end portion is mitigated, making dielectric breakdown less likely to occur.

In the present invention, the inner walls of the plurality of trenches are covered with an insulating film. With this configuration, it is possible to obtain a structure in which the inside of the plurality of trenches are filled with the anode electrode.

The Schottky barrier diode according to the present invention may further include an insulating layer formed on the drift layer, and the anode electrode may be formed on the insulating layer and brought into Schottky contact with the drift layer through an opening formed in the insulating layer. With this configuration, a so-called field plate structure can be obtained, allowing further mitigation of an electric field to be applied to the bottom portion of the trench positioned at the end portion.

### [Advantageous Effects of the Invention]

As described above, according to the present invention, there can be provided a gallium oxide Schottky barrier diode in which dielectric breakdown due to electric field concentration hardly occurs.

### [Brief Description of Drawings]

FIG. 1 is a schematic cross-sectional view illustrating the configuration of a Schottky barrier diode 100 according to a first embodiment of the present invention.
FIG. 2 is a schematic cross-sectional view illustrating the configuration of a Schottky barrier diode 200 according to a second embodiment of the present invention.
FIG. 3 a schematic cross-sectional view for explaining a structure of a simulation model of Comparative Example 1.
FIGs. 4A and 4B are views each illustrating a simulation result of Comparative Example 1, where FIG. 4A is a view illustrating electric field strength in a cross section, and FIG. 4B is a graph illustrating the relationship between a lateral position and the maximum electric field strength.
FIGs. 5A and 5B are views each illustrating a simulation result of Example 1, where FIG. 5A is a view illustrating electric field strength in a cross section, and FIG. 5B is a graph illustrating the relationship between a lateral position and the maximum electric field strength.
FIG. 6 a schematic cross-sectional view for explaining a structure of a simulation model of Comparative Example 2.
FIGs. 7A and 7B are views each illustrating a simulation result of Comparative Example 2, where FIG. 7A is a view illustrating electric field strength in a cross section, and FIG. 7B is a graph illustrating the relationship between a lateral position and the maximum electric field strength.
FIGs. 8A and 8B are views each illustrating a simulation result of Example 2, where FIG. 8A is a view illustrating electric field strength in a cross section, and FIG. 8B is a graph illustrating the relationship between a lateral position and the maximum electric field strength.
FIG. 9 is a graph indicating a simulation result of Example 3.

### [Mode for Carrying Out the Invention]

Preferred embodiments of the present invention will be explained below in detail with reference to the accompanying drawings.

### <First Embodiment>

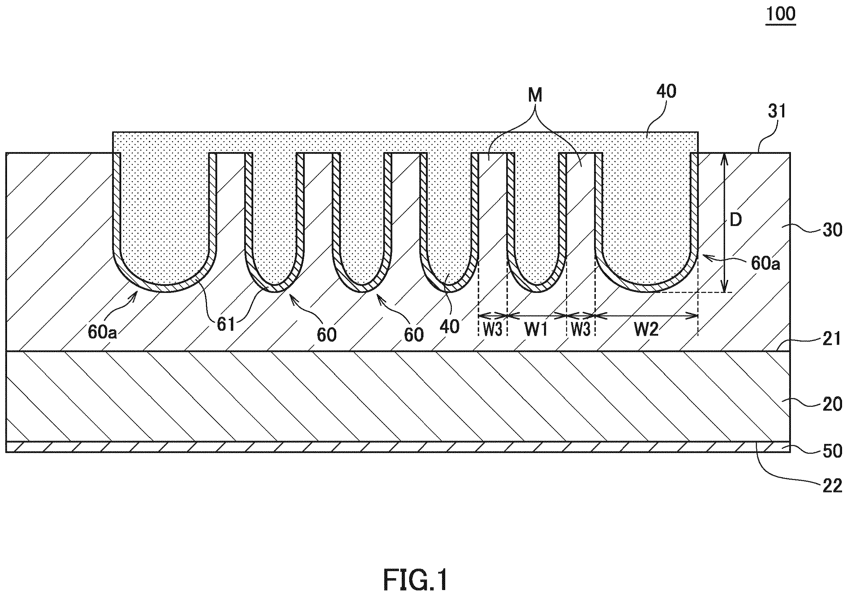

FIG. 1 is a schematic cross-sectional view illustrating the configuration of a Schottky barrier diode 100 according to the first embodiment of the present invention.

As illustrated in FIG. 1, the Schottky barrier diode 100 according to the present embodiment has a semiconductor substrate 20 and a drift layer 30, both of which are made of gallium oxide (β-Ga₂O₃). The semiconductor substrate 20 and drift layer 30 are each introduced with silicon (Si) or tin (Sn) as an n-type dopant. The concentration of the dopant is higher in the semiconductor substrate 20 than in the drift layer 30, whereby the semiconductor substrate 20 and the drift layer 30 function as an n⁺ layer and an n⁻layer, respectively.

The semiconductor substrate 20 is obtained by cutting a bulk crystal formed using a melt-growing method, and the thickness thereof is about 250 µm. Although there is no particular restriction on the planar size of the semiconductor substrate 20, the planar size is generally selected in accordance with the amount of current flowing in the element and, when the maximum amount of forward current is about 20A, the planar size may be set to about 2.4 mm × 2.4 mm.

The semiconductor substrate 20 has an upper surface 21 positioned on the upper surface side in a mounted state and a back surface 22 positioned on the lower surface side in a mounted state. The drift layer 30 is formed on the entire upper surface 21. The drift layer 30 is a thin film obtained by epitaxially growing gallium oxide on the upper surface 21 of the semiconductor substrate 20 using a reactive sputtering method, a PLD method, an MBE method, an MOCVD method, or an HVPE method. Although there is no particular restriction on the film thickness of the drift layer 30, the film thickness is generally selected in accordance with the backward withstand voltage of the element and, in order to ensure a withstand voltage of about 600 V, the film thickness may be set to, **e.g.,** about 7 µm.

An anode electrode 40 brought into Schottky contact with the drift layer 30 is formed on an upper surface 31 of the drift layer 30. The anode electrode 40 is formed of metal such as platinum (Pt), palladium (Pd), gold (Au), nickel (Ni), molybdenum (Mo), Copper (Cu) or the like. The anode electrode 40 may have a multilayer structure of different metal films, such as Pt/Au, Pt/Al, Pd/Au, Pd/Al, Pt/Ti/Au, or Pd/Ti/Au. On the other hand, a cathode electrode 50 brought into ohmic contact with the semiconductor substrate 20 is formed on the back surface 22 of the semiconductor substrate 20. The cathode electrode 50 is formed of metal such as titanium (Ti) . The cathode electrode 50 may have a multilayer structure of different metal films, such as Ti/Au or Ti/Al.

In the present embodiment, a plurality of trenches 60 are formed in the drift layer 30. Each trench 60 is formed at a position overlapping the anode electrode 40 in a plan view, and the inner wall thereof is covered with an insulating film 61 made of HfO₂. The inside of the trench 60 is filled with the same material as the anode electrode 40. In the present embodiment, since the plurality of trenches 60 are formed in the drift layer 30, the anode electrode 40 may be made of a material having a low work function such as molybdenum (Mo) or copper (Cu). Further, since the plurality of trenches 60 are formed in the drift layer 30, the dopant concentration of the drift layer 30 can be increased to about 5 × 10¹⁶ cm⁻³.

Apart of the drift layer 30 positioned between adjacent trenches 60 constitutes a mesa region M. The mesa region M becomes a depletion layer when a backward voltage is applied between the anode electrode 40 and the cathode electrode 50, so that the channel region of the drift layer 30 is pinched off. This significantly suppresses a leak current upon application of a backward voltage.

In the Schottky barrier diode having such a configuration, an electric field concentrates on the bottom portion of a trench 60a positioned at the end portion, and thus dielectric breakdown is likely to occur at this portion. Considering this, in the Schottky barrier diode 100 according to the present embodiment, the trench width of the trench 60a positioned at the end portion is selectively increased. That is, assuming that the width of the trench 60 that is not positioned at the end portion is W1 and that the width of the trench 60a positioned at the end portion is W2,
W1 < W2 is satisfied.

The width W1 of the trench 60 that is not positioned at the end portion and width W3 of the mesa region M need to be determined based on electrical characteristics required for the Schottky barrier diode 100 and are therefore difficult to change freely. On the other hand, the width W2 of the trench 60a positioned at the end portion is comparatively freely changed since it has little influence on the electrical characteristics of the Schottky barrier diode 100.

Further, in the Schottky barrier diode 100 according to the present embodiment, the trench width of the trench 60a positioned at the end portion is selectively increased, so that the concentration of an electric field on the trench 60a positioned at the end potion is mitigated as compared to when all the trenches 60 are designed to have the same width (= W1). This is because when the width W2 of the trench 60a positioned at the end portion is increased, the curvature radius of the bottom portion increases. Alternatively, not forming an embodiment of the invention, an edge part constituted by the bottom portion as viewed in cross section is divided into two parts. As a result, dielectric breakdown hardly occurs around the bottom portion of the trench 60a positioned at the end portion.

As described above, the trench width of the trench 60a positioned at the end portion is selectively increased, so that the Schottky barrier diode 100 according to the present embodiment can prevent dielectric breakdown due to electric field concentration. Further, at the time of manufacture, all the trenches 60 including the trench 60a positioned at the end portion can be formed at the same time, preventing the number of manufacturing processes from being increased.

Although the inner wall of the trench 60 is covered with the insulating film 61, and the inside of the trench 60 is filled with the same material as the anode electrode 40 in the present embodiment, in an embodiment not forming part of the present invention the trench 60 may be filled with a semiconductor material of an opposite conductivity type (p-type in the present embodiment) without use of the insulating film 61.

### <Second Embodiment>

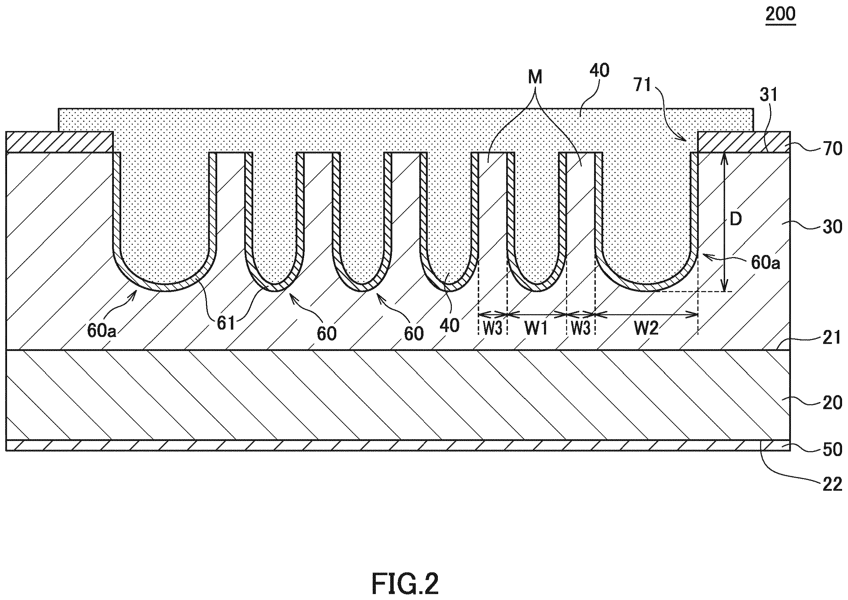

FIG. 2 is a schematic cross-sectional view illustrating the configuration of a Schottky barrier diode 200 according to a second embodiment of the present invention.

As illustrated in FIG. 2, the Schottky barrier diode 200 according to the second embodiment differs from the Schottky barrier diode 100 according to the first embodiment in that an insulating layer 70 is formed on the drift layer 30. Other configurations are basically the same as those of the Schottky barrier diode 100 according to the first embodiment, so the same reference numerals are given to the same elements, and overlapping description will be omitted.

The insulating layer 70, which is made of an insulating material such as silicon oxide, is formed so as to cover an upper surface 31 of the drift layer 30 and has an opening 71 through which the trenches 60 are exposed. Apart of the anode electrode 40 is formed on the insulating layer 70 and the remaining part thereof is brought into Schottky contact with the drift layer 30 through the opening 71. As a result, a so-called field plate structure can be obtained, allowing further mitigation of an electric field to be applied to the bottom portion of the trench 60a positioned at the end portion.

It is apparent that the present invention is not limited to the above embodiments, but may be modified and changed without departing from the scope of the invention, which is defined by the appended claims.

### [Example 1]

A simulation model of Example 1 having the same structure as the Schottky barrier diode 100 illustrated in FIG. 1 was assumed, and electric field strength obtained upon application of a backward voltage between the anode electrode 40 and the cathode electrode 50 was simulated. The dopant concentration of the semiconductor substrate 20 was set to 1 × 10¹⁸ cm⁻³, and the dopant concentration of the drift layer 30 was set to 5 × 10¹⁶ cm⁻³. The thickness of the drift layer 30 was set to 7 µm. The depth D and width W1 of the trench 60 were set to 3 µm and 1 µm, respectively, the mesa width W3 of the mesa region M was set to 2 µm, and the insulating film 61 formed on the inner wall of the trench 60 was an HfO₂ film having a thickness of 50 nm. The width W2 of the trench 60a positioned at the end portion was set to 10 µm. The anode electrode 40 was made of gold (Au), and the cathode electrode 50 was made of a laminated film of Ti/Au.

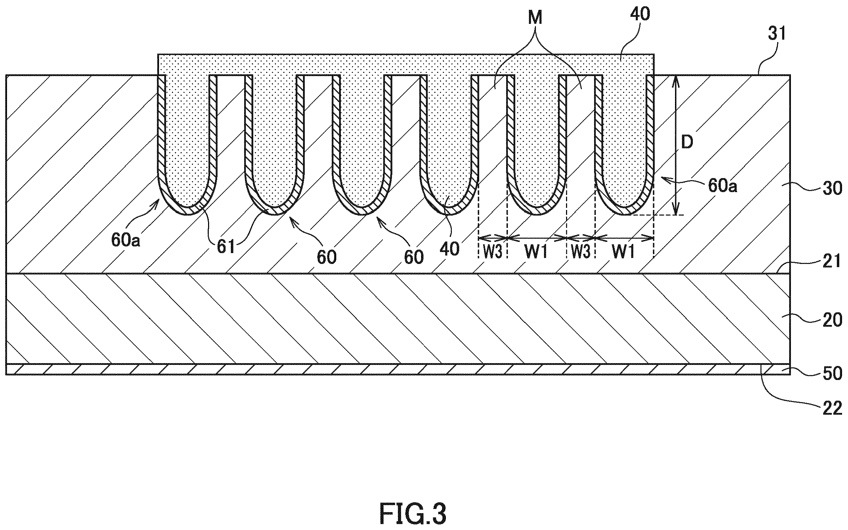

Further, for comparison, as illustrated in FIG. 3, a simulation model of Comparative Example 1 having the same structure as that of Example 1 except that the width of the trench 60a positioned at the end portion was set to be the same as the width W1 of the trench 60 was assumed, and electric field strength obtained upon application of a backward voltage between the anode electrode 40 and the cathode electrode 50 was simulated.

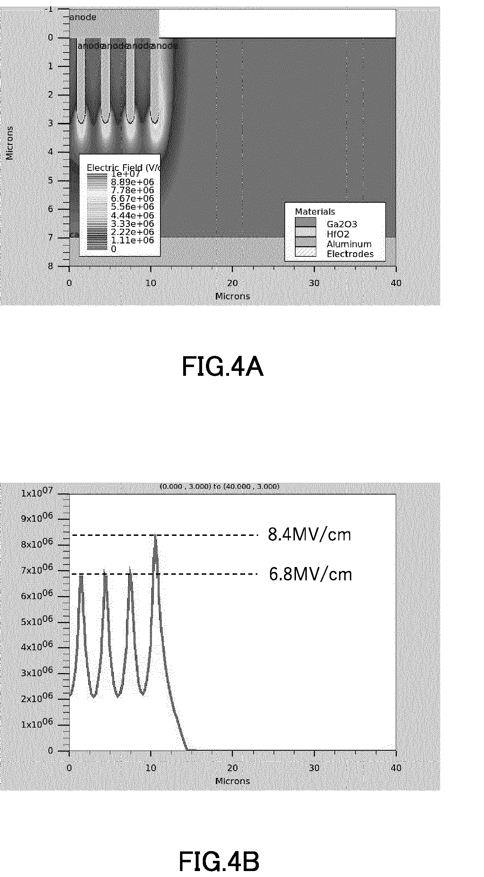

FIGs. 4A and 4B are views each illustrating a simulation result of Comparative Example 1. FIG. 4A is a view illustrating electric field strength in a cross section, and FIG. 4B is a graph illustrating the relationship between a lateral position and the maximum electric field strength. The lateral positions in FIGs. 4A and 4B correspond to each other. As illustrated in FIGs. 4A and 4B, in the simulation model of Comparative Example 1, an electric field concentrated on the bottom portion of the trench 60a positioned at the end portion, and the maximum value thereof was 8.4 MV/cm. This value exceeds 8 MV/cm which is the dielectric breakdown electric field strength of gallium oxide, so that, with this device structure, dielectric breakdown may occur at the bottom portion of the trench 60a, failing to obtain a required withstand voltage.

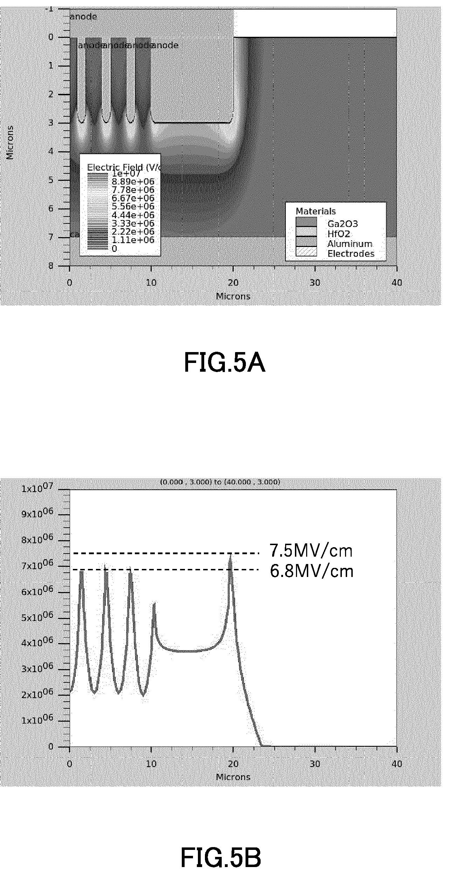

FIGs. 5A and 5B are views each illustrating a simulation result of Example 1, wherein the curvature of the outermost trench 60a as indicated in Figure 1 is not shown. FIG. 5A is a view illustrating electric field strength in a cross section, and FIG. 5B is a graph illustrating the relationship between a lateral position and the maximum electric field strength. The lateral positions in FIGs. 5A and 5B correspond to each other. As illustrated in FIGs. 5A and 5B, in the simulation model of Example 1, as a result of an increase in the width of the trench 60a positioned at the end portion, the edge part on which an electric field concentrated was divided into two parts, dispersing the electric field. This reduced the maximum value of the electric field to 7.5 MV/cm which was equal to or less than the dielectric breakdown electric field strength of gallium oxide. Thus, with this device structure, it is possible to produce a gallium oxide Schottky barrier diode satisfying a required withstand voltage.

Although the electric field concentrated to some extent on the bottom portion of the trench 60 that was not positioned at the end portion, there was no difference between Example 1 and Comparative Example 1 in terms of the value of the electric field, and the maximum value of the electric field was 6.8 MV/cm in both Example 1 and Comparative Example 1.

### [Example 2]

A simulation model of Example 2 having the same structure as that of the Schottky barrier diode 200 illustrated in FIG. 2 was assumed, and electric field strength obtained upon application of a backward voltage between the anode electrode 40 and the cathode electrode 50 was simulated. The insulating layer 70 was made of silicon oxide having a thickness of 300 nm, and a field plate length of 10 µm was set. Other conditions were the same as those for the simulation model of Example 1.

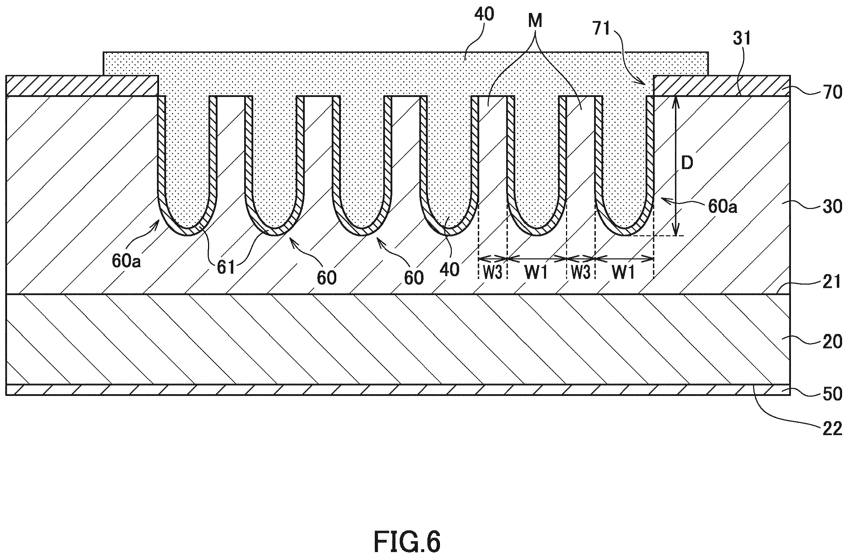

Further, for comparison, as illustrated in FIG. 6, a simulation model of Comparative Example 2 having the same structure as that of Example 2 except that the width of the trench 60a positioned at the end portion was set to be the same as the width W1 of the trench 60 was assumed, and electric field strength obtained upon application of a backward voltage between the anode electrode 40 and the cathode electrode 50 was simulated.

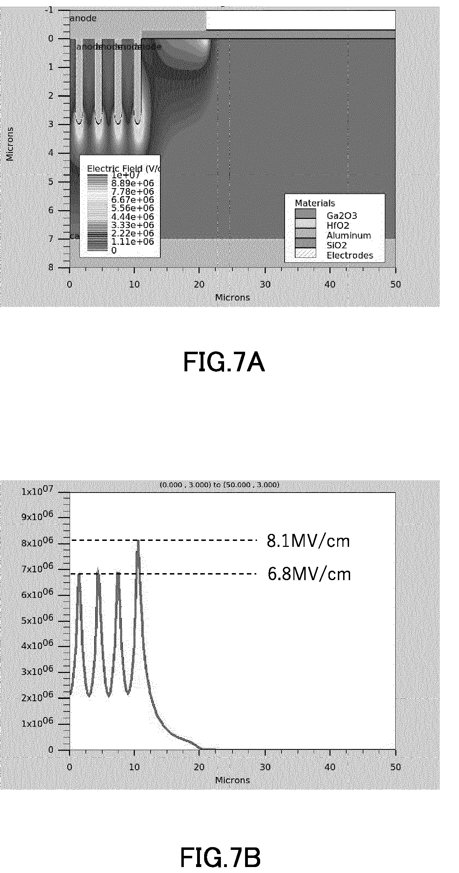

FIGs. 7A and 7B are views each illustrating a simulation result of Comparative Example 2. FIG. 7A is a view illustrating electric field strength in a cross section, and FIG. 7B is a graph illustrating the relationship between a lateral position and the maximum electric field strength. The lateral positions in FIGs. 7A and 7B correspond to each other. As illustrated in FIGs. 7A and 7B, in the simulation model of Comparative Example 2, an electric field concentrated on the bottom portion of the trench 60a positioned at the end portion, and the maximum value thereof was 8.1 MV/cm. Thus, with this device structure, dielectric breakdown may occur at the bottom portion of the trench 60a, failing to obtain a required withstand voltage.

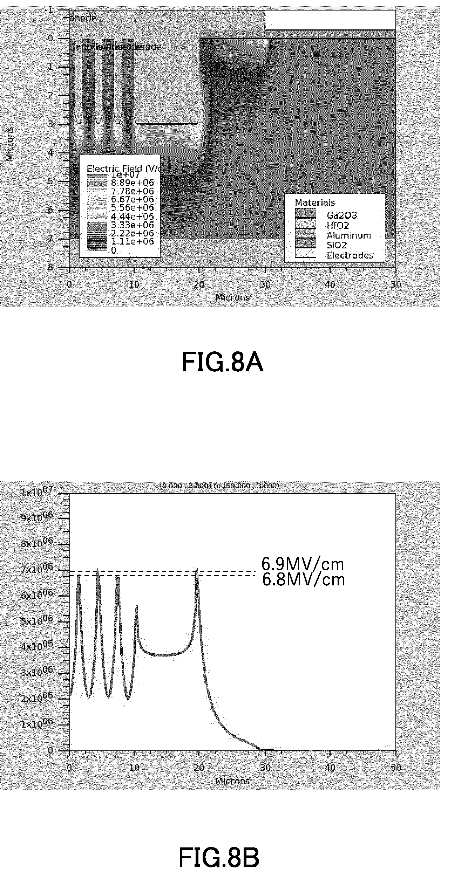

FIGs. 8A and 8B are views each illustrating a simulation result of Example 2, wherein the curvature of the outermost trench 60a as indicated in Figure 2 is not shown. FIG. 8A is a view illustrating electric field strength in a cross section, and FIG. 8B is a graph illustrating the relationship between a lateral position and the maximum electric field strength. The lateral positions in FIGs. 8A and 8B correspond to each other. As illustrated in FIGs. 8A and 8B, in the simulation model of Example 2, as a result of an increase in the width of the trench 60a positioned at the end portion, the edge part on which an electric field concentrated was divided into two parts, dispersing the electric field. This reduced the maximum value of the electric field to 6.9 MV/cm which was equal to or less than the dielectric breakdown electric field strength of gallium oxide. Thus, with this device structure, it is possible to produce a gallium oxide Schottky barrier diode satisfying a required withstand voltage.

Although the electric field concentrated to some extent on the bottom portion of the trench 60 that was not positioned at the end portion, there was no difference between Example 2 and Comparative Example 2 in terms of the value of the electric field, and the maximum value of the electric field was 6.8 MV/cm in both Example 2 and Comparative Example 2.

### [Example 3]

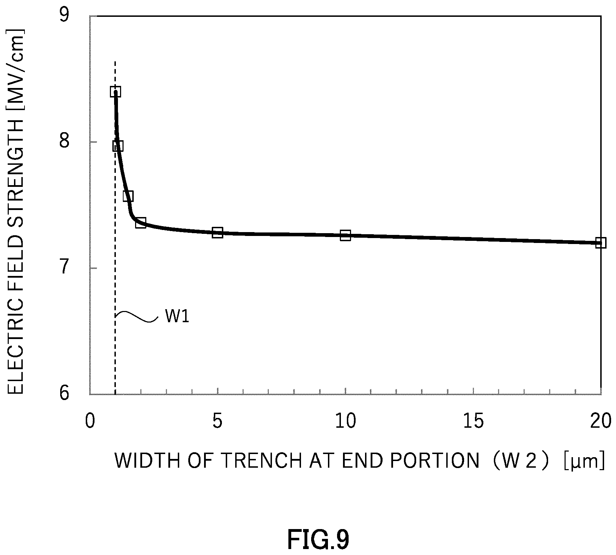

A simulation model of Example 3 having the same structure as that of Example 1 was assumed, in which the width W2 of the trench 60a positioned at the end portion was changed from 1 µm to 20 µm, and the electric field strength obtained upon application of a backward voltage between the anode electrode 40 and the cathode electrode 50 was simulated. The simulation result is illustrated in FIG. 9.

As illustrated in FIG. 9, it was found that when the width W2 of the trench 60a positioned at the end portion exceeds 1 µm of the width W1 of the trench 60, that is, when W1 < W2 is satisfied, the maximum value of an electric field became equal to or less than 8 MV/cm which is the dielectric breakdown electric field strength of gallium oxide.

### [Reference Signs List]

- 20: semiconductor substrate
- 21: upper surface of semiconductor substrate
- 22: back surface of semiconductor substrate
- 30: drift layer
- 31: upper surface of the drift layer
- 40: anode electrode
- 50: cathode electrode
- 60: trench
- 60a: trench positioned at end portion
- 61: insulating film
- 70: insulating layer
- 71: opening
- 100, 200: Schottky barrier diode
- M: mesa region

## Claims

1. A Schottky barrier diode (100) comprising:
a semiconductor substrate (20) made of gallium oxide;
a drift layer (30) made of gallium oxide and provided on the semiconductor substrate (20);
an anode electrode (40) that is in Schottky contact with the drift layer (30); and
a cathode electrode (50) that is in ohmic contact with the semiconductor substrate (20),
wherein the drift layer has a plurality of trenches (60, 60a) formed in a position overlapping the anode electrode (40) in a plan view,
wherein the inner walls of the plurality of trenches are covered with an insulating film (61) and the inside of the plurality of trenches is filled with the anode electrode (40),
**characterized in that**
- an outermost trench (60a) among the plurality of trenches has a selectively increased width (W2),
- each of the trenches (60, 60a) of the plurality of trenches (60, 60a) has a curved bottom portion,
- the radius of curvature of the bottom portion of said outermost trench (60a) is larger than the radius of curvature of the bottom portion of the trenches (60) among the plurality of the trenches (60, 60a) not being an outermost trench (60a).

2. The Schottky barrier diode as claimed in claim 1, further comprising an insulating layer (70) formed on the drift layer (30),
wherein the anode electrode (40) is formed on the insulating layer (70) and is in Schottky contact with the drift layer (30) through an opening (71) formed in the insulating layer (70).

3. The Schottky barrier diode (100) as claimed in claim 2, wherein the insulating layer (70) does not overlap with any one of the plurality of trenches (60, 60a).

## Patentansprüche

1. Schottky-Barrieren-Diode (100), aufweisend:
ein Halbleitersubstrat (20) gefertigt aus Galliumoxid;
eine aus Galliumoxid gefertigte und auf dem Halbleitersubstrat (20) angeordnete Driftschicht (30);
eine Anodenelektrode (40), die mit der Driftschicht (30) einen Schottky-Kontakt bildet; und
eine Kathodenelektrode (50), die mit dem Halbleitersubstrat (20) einen ohmschen Kontakt bildet,
wobei die Driftschicht eine Mehrzahl von Gräben (60, 60a) aufweist, die in einer Position ausgebildet sind, die in der Draufsicht die Anodenelektrode (40) überlappt,
wobei die Innenwände der Mehrzahl von Gräben mit einem Isolationsfilm (61) bedeckt sind und das Innere der Mehrzahl von Gräben mit der Anodenelektrode (40) gefüllt ist,
**dadurch gekennzeichnet, dass**
- ein äußerster Graben (60a) der Mehrzahl von Gräben eine selektiv vergrößerte Breite (W2) aufweist,
- jeder Graben (60, 60a) der Mehrzahl von Gräben (60, 60a) einen gekrümmten Bodenbereich aufweist und
- der Krümmungsradius des Bodenbereichs des äußersten Grabens (60a) größer ist als der Krümmungsradius des Bodenbereichs derjenigen Gräben (60) der Mehrzahl von Gräben (60, 60a), die nicht der äußerste Graben (60a) sind.

2. Schottky-Barrieren-Diode nach Anspruch 1, weiterhin aufweisend eine auf der Driftschicht (30) gebildete Isolationsschicht (70),
wobei die Anodenelektrode (40) auf der Isolationsschicht (70) ausgebildet ist und über eine in der Isolationsschicht (70) ausgebildete Öffnung (71) mit der Driftschicht (30) in Schottky-Kontakt steht.

3. Schottky-Barrieren-Diode (100) nach Anspruch 2, wobei die Isolationsschicht (70) keinen der Gräben (60, 60a) der Mehrzahl von Gräben (60, 60a) überlappt.

## Revendications

1. Diode à barrière Schottky (100) comprenant :
un substrat semiconducteur (20) en oxyde de gallium ;
une couche de dérive (30) en oxyde de gallium disposée sur le substrat semiconducteur (20) ;
une électrode d'anode (40) en contact Schottky avec la couche de dérive (30) ; et
une électrode de cathode (50) en contact ohmique avec le substrat semiconducteur (20),
la couche de dérive présentant une pluralité de tranchées (60, 60a) formées à une position chevauchant l'électrode d'anode (40) en vue en plan,
les parois internes de ladite pluralité de tranchées étant revêtues d'un film isolant (61) et l'intérieur de ladite pluralité de tranchées étant rempli par l'électrode d'anode (40),
**caractérisée en ce que** :
- une tranchée la plus externe (60a) parmi ladite pluralité de tranchées présente une largeur sélectivement augmentée (W2) ;
- chacune des tranchées (60, 60a) de ladite pluralité de tranchées (60, 60a) présente une partie de fond courbe ; et
- le rayon de courbure de la partie de fond de ladite tranchée la plus externe (60a) est supérieur au rayon de courbure de la partie de fond des tranchées (60) de ladite pluralité de tranchées (60, 60a) qui ne sont pas la tranchée la plus externe (60a).

2. Diode à barrière Schottky selon la revendication 1, comprenant en outre une couche isolante (70) formée sur la couche de dérive (30),
dans laquelle l'électrode d'anode (40) est formée sur la couche isolante (70) et est en contact Schottky avec la couche de dérive (30) à travers une ouverture (71) formée dans la couche isolante (70).

3. Diode à barrière Schottky (100) selon la revendication 2, dans laquelle la couche isolante (70) ne chevauche aucune des tranchées (60, 60a) de ladite pluralité de tranchées (60, 60a).
